Europäisches Patentamt

European Patent Office

Office européen des brevets

(11) Publication number: **0 385 454 A2**

# EUROPEAN PATENT APPLICATION

(21) Application number: **90103934.7**

(51) Int. Cl.5: **H01L 27/148**

(22) Date of filing: **01.03.90**

(30) Priority: **01.03.89 IT 4769889**

(43) Date of publication of application:
**05.09.90 Bulletin 90/36**

(84) Designated Contracting States:
**BE DE FR GB NL SE**

(71) Applicant: **SELENIA INDUSTRIE
ELETTRONICHE ASSOCIATE S.p.A.**
**Via Tiburtina, KM 12.400**
**I-00131 Roma(IT)**

(72) Inventor: **Liberati, Riccardo Maria**
**Via della Rustica 277**
**I-00155 Roma(IT)**
Inventor: **Sparvieri, Nicola**
**Via Massimi 25**
**I-00136 Roma(IT)**

(74) Representative: **Gustorf, Gerhard, Dipl.-Ing.**
**Patentanwalt Dipl.-Ing. Gerhard Gustorf**
**Bachstrasse 6 A**
**D-8300 Landshut(DE)**

(54) **Improvement to the manufacturing of bidimensional linear IR detectors and related manufacturing process.**

(57) The invention relates to an IR detector which makes use of a superconductive film set on a substrate which has the purpose of eliminating the cross-talk problems due to a ground contact which has a non null resistance.

The invention belongs to the field of infrared radiation detectors and finds attractive applications in the multi-spectral arrays adopted by early warning and thermal imaging systems.

FIG. 1

## Improvement to the manufacturing of bidimensional linear IR detectors and related manufacturing process

The invention relates to an improvement to linear and bidimensional IR detectors through a technique which applies a superconductive film between photosensitive elements, so as to act as a common ground path, which, having a null resistance, does not introduce any voltage drop between any pair of photosensitive elements.

The deposition of such superconductive film may be achieved by:
- laser deposition, starting from a ceramic target;
- sputtering from a metal or ceramic target onto a silicon or other wafer;
- MBE technique.

After deposition, the superconductive film must be drawn at high temperature, preferably about 900° C, in an oxygen or ozone enriched oxygen atmosphere (in accordance with the directives of SELENIA-INFN-INFM Italian patent application no. 47521 A/88 of 12.1.88.

At the end of the deposition process, the linear detector(s) is (are) glued (adhered) by placing them in their due position and then the conductive films are deposited. The contacts are then deposited by sputtering or thermal evaporation (or other) onto both sides of the photosensitive elements; thereafter the superconductive film is passivated by means of a dielectric layer, such as $Si_3N_4$.

The invention presented belongs to the photoconductive photovoltaic sensors operating at cryogenic temperatures and finds specific application in the field of infrared sensors such as those for night vision, missile seekers etc.

The invention presented serves to solve the common ground problems of bi-spectral array sensors.

In fact till now the traditional conductive materials always required to separate sensor grounds from each other, or at least to gather their ground points into a limited group of sensors (6, 7 each) providing obvious inplementation drawbacks.

This invention solves such problem and, further, it lowers the total number of connections.

Conventional structures have 2n external connections (where n is the number of sensors), whereas this invention lowers the number of connections to n + 1, therefore reducing size and welding problems considerably.

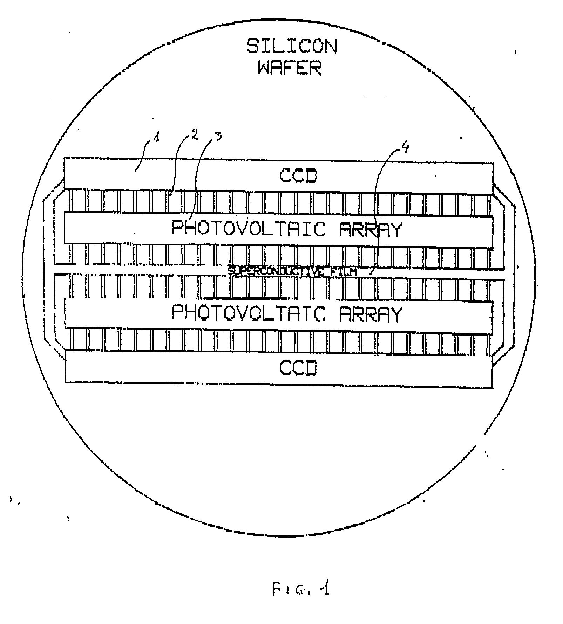

With an illustrative and non-limiting purpose, the invention will now be described in detail with reference to figure 1, which schematically illustrates an TR detector which shows:
- the circuit elements 1 for signal extraction,
- the metal paths 2,
- the array of photosensitive elements 3,

- the superconductive film 4 which represents the innovative feature of the invention.

In the following, the operations are described which are required to implement the detector according to the invention in the following order:

a) a superconductive film is deposited on the substrate;

b) the superconductive film is thereafter drawn or tempered (an operation which, for best results, must take place in an ozone enriched environment);

c) the photosensitive elements are glued to their expected pads;

d) ohmic contacts are formed (using known techniques) between the photosensitive elements and the superconductive ground path on one side and the related circuit path on the other;

e) finally, passivation of the entire focal plane is performed by deposition of the dielectric film.

The main feature of the invention is therefore that of eliminating crosstalk between photosensitive elements, generally caused by a negative ground contact. This implementation technique also simplifies the assembling process.

### Claims

1. Linear or bidimensional IR detector, where a single superconductive ground rail (4) is set between the photosensitive pixel elements (3), at high temperature so as to eliminate crosstalk phenomena.

2. Linear or bidimensional IR detector according to claim 1, characterized by the following techniques:

a) deposition on the superconductive substrate;

b) drawing (tempering) of such superconductive film, preferably in ozone-enriched environment;

c) glueing of the photosensitive elements on their final locations;

d) forming of ohmic contacts (by known techniques) between photosensitive elements (3) and the superconductive ground rail (superconductive film) on one side and circuit elements (1) for signal extraction on the other;

e) passivation of the entire focal plane by dielectic film deposition.

3. Linear or bidimensional IR detector according to claim 1 or 2, made up of one or more elements in succession:
Circuit elements
Metal rails

Photosensitive elements
Metal rails
Superconductive film
Metal rails
Photosensitive elements
Metal rails
Circuit elements
Metal rails
Element array ...

FIG. 1